# EUROPEAN PATENT APPLICATION

(11) **EP 1 592 059 A2**
(43) Date of publication of application: **02.11.2005**
(21) Application number: 05003160.8
(22) Date of filing: 15.02.2005
(51) Int. Cl.: H01L 23/367, H01L 23/373

(54) **Heat sink and method for processing surfaces thereof**

(30) Priority: 29.04.2004 KR 2004030097
(71) Applicant: LG ELECTRONICS INC., Seoul 150-010 (KR)
(72) Inventor: An, Kwang Hyup, Kangdong-ku, Seoul 134-061 (KR); Chung, Moon Kee, Youngdeungpo-ku, Seoul 150-082 (KR); Lee, Jeong Ho, Koyang-si, Kyungki-do 411-360 (KR); Rew, Ho Seon, Mapo-ku, Seoul 121-080 (KR); Kim, Jong Hoon, Kunpo-si, Kyungki-do 435-044 (KR)
(74) Representative: TER MEER - STEINMEISTER & PARTNER GbR

(57) **Abstract**

A heat sink and a method for processing the surfaces of the heat sink are disclosed. The heat sink and a method for processing the surfaces of the heat sink can improve performance of heat dissipation of the heat sink per volume as a plurality of fine wires (56) based on nanometer or micrometer units are grown on the surfaces of the base (52) and heat-dissipative fins (54) of the heat sink through oxidation process. Here, the total volume of the heat sink is scarcely increased, but rather their surface area and surface roughness are increased.

## Description

### BACKGROUND OF THE INVENTION

### Field of the Invention

The present invention relates to a heat sink for dissipating heat from a heat generating element, and more particularly to a heat sink having a plurality of fine wires grown on the surfaces thereof capable of dissipating heat from a heat generating element, and a method for processing the surfaces of the heat sink.

### Description of the Related Art

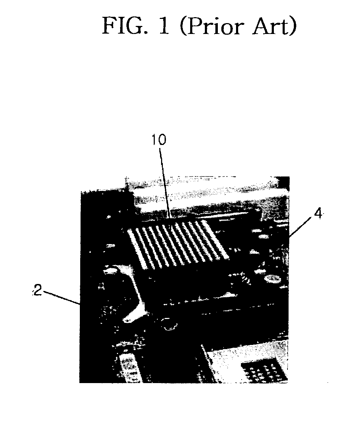

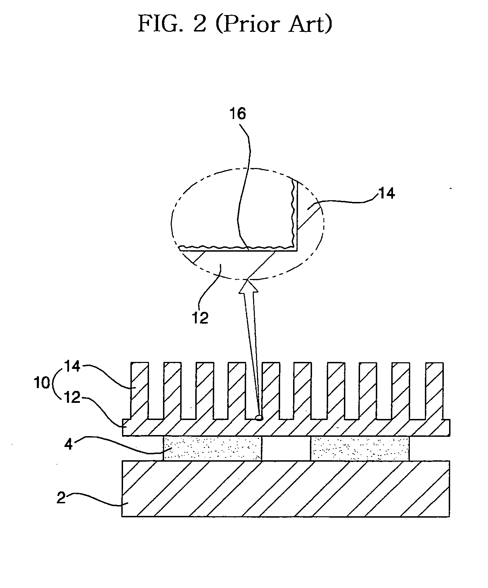

Fig. 1 is a perspective view illustrating a prior art heat sink, and Fig. 2 is a cross-sectional view illustrating a prior art heat sink.

As shown in Figs. 1 and 2, the prior art heat sink 10 is mounted on a heat generating element 4 such as a power module, a CPU (Central Processing Unit), a power transistor, which are mounted on a PCB (Printed Circuit Board) 2, to dissipate heat generated therefrom and to prevent thermal aging of the heat generating element 4.

The heat sink 10 includes a base 12 attached on the heat generating element 4, a plurality of heat-dissipative fins 14 extending upwardly from the base 12 and evenly spaced from each other. The heat sink 10 is made of relatively inexpensive aluminum alloy having relatively high heat dissipation.

Meanwhile, the heat sink 10 forms an oxide film 16 on its surfaces using an Alumite process or anodizing process, which is a kind of oxide film forming methods of aluminum alloy, such that heat dissipation by radiation is smoothly performed therefrom.

The oxide film 16 is formed on the surfaces of the heat sink 10 as the followings. Firstly, in an electrolytic solution, metal with which the surfaces of the heat sink 10 are coated is connected to an anode electrode and non-active metal is connected to a cathode electrode. Next, the heat sink 10 is immersed in the electrolytic solution. After that, electric current is applied to the electrolytic solution through the anode and cathode electrodes, thereby forming the oxide film 16 on the surfaces of the heat sink 10.

The heat sink 10 coated with the oxide film 16 is prevented from oxidizing and has a relatively large corrosion-resistance. Also, since the surfaces are dull, radiation energy outputted from the surfaces is randomly radiated in light beam form. Therefore, the heat dissipation efficiency from the surfaces of the heat sink are higher by 3% to 10% than that of the heat sink of which surfaces are not processed.

However, since the rate of diffuse reflection of the oxide film 16 cannot be more increased by the prior art technology, the capacity of the heat sink 10 must be increased or the heat exchange area of the heat sink 10 must be increased as the heat-dissipative fins 14 are densely formed on the base to improve heat dissipation of the heat sink 10. Therefore, the prior art heat sink has disadvantages in that its size is increased and space to densely install the heat dissipative fins 14 is restricted.

### SUMMARY OF THE INVENTION

Therefore, the present invention has been made in view of the above problems, and it is an object of the present invention to provide a heat sink capable of improving performance of heat dissipation as its surface area is increased and its surface roughness is increased without changing its volume.

In accordance with the present invention, the above and other objects can be accomplished by the provision of a heat sink, comprising a base (52) mounted on a heat generating element; and at least one or more than one heat-dissipative fins (54) extending upwardly from the base (52), wherein the base (52) or heat-dissipative fins (54) have a plurality of fine wires (56) formed on the surfaces thereof.

Preferably, the plurality of fine wires (56) may be copper oxide.

Preferably, the plurality of fine wires (56) may have 0.1µm to 100µm in height from the surfaces of the base (52) or heat dissipative fins (54).

Preferably, the plurality of fine wires (56) may be 1nm to 100nm in width of cross-sectional area thereof.

Preferably, the heat sink may be made of copper such that the plurality of fine wires (56) are grown on the surfaces thereof while the surfaces are oxidized.

In accordance with another aspect of the present invention, there is provided a method for processing surfaces of a heat sink, comprising the steps of immersing the heat sink in an oxide solution, and growing fine wires (56) of oxide on the surfaces of the heat sink.

Preferably, the heat sink may be coated with copper on the surfaces thereof such that the fine wires (56) can be grown thereon.

Preferably, the heat sink may be made of copper such that the plurality of fine wires (56) are grown on the surfaces thereof while the surfaces are oxidized.

Preferably, the fine wires (56) may have a growth temperature of 60°C to 100°C.

Preferably, the fine wires may have a growth time of 1 minute to 10 minutes.

Preferably, the oxide solution may include NaOH or NaClO₂.

### BRIEF DESCRIPTION OF THE DRAWINGS

The above and other objects, features and other advantages of the present invention will be more clearly understood from the following detailed description taken in conjunction with the accompanying drawings, in which:
Fig. 1 is a perspective view illustrating a prior art heat sink;
Fig. 2 is a cross-sectional view illustrating a prior art heat sink;
Fig. 3 is a cross-sectional view illustrating a heat sink according to the present invention;
Fig. 4 is a picture taking a state wherein copper is coated to the surfaces of the heat sink according to the present invention;
Fig. 5 is a picture taking a state wherein fine wires are grown on the surfaces of the heat sink for two minutes according to the present invention;
Fig. 6 is a picture taking a state wherein fine wires are grown on the surfaces of the heat sink for three minutes according to the present invention; and
Fig. 7 is a picture taking a state wherein fine wires are grown on surfaces of the heat sink for five minutes according to the present invention.

### DESCRIPTION OF THE PREFERRED EMBODIMENTS

With reference to the attached drawings, preferred embodiments of the present invention are described in detail below.

The heat sink and method for processing the surfaces of the same according to the present invention may be modified in various modifications. Preferred embodiment of the present invention is described in detail below. Since the basic structure of the heat sink of the present invention is the same that as the prior art, the detailed description therefor is omitted below.

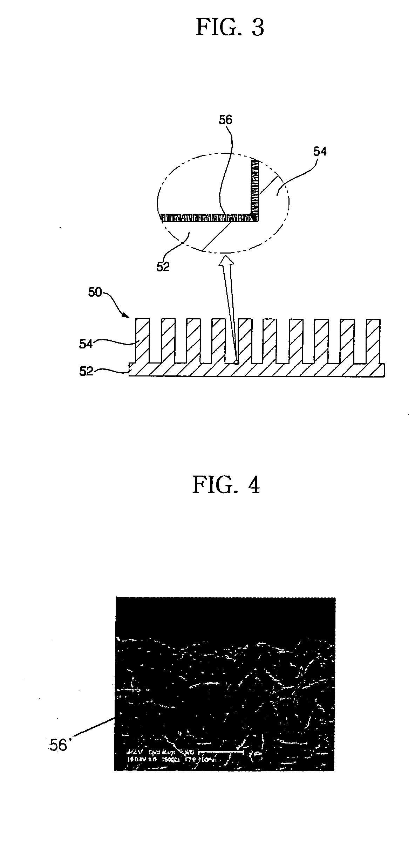

Fig. 3 is a cross-sectional view illustrating a heat sink according to the present invention.

As shown in Fig. 3, the heat sink 50 includes a base 52 attached on a heat generating element, and at least one or more than one heat dissipative fins 54 extending upwardly from the base 52. Especially, the base 52 or the heat-dissipative fins 54 have a plurality of fine wires evenly formed on the surfaces such that either the surface area or surface roughness can be increased.

The fine wires 56 are made of a metal having relatively high thermal conductivity such that a heat dissipation effect of the heat sink 50 can be increased. Here, the kinds of metal having the higher thermal conductivity are shown in the following Table 1.

**Table 1:**

| [ Thermal Conductivity of Matter] | |
|---|---|
| Matter | Thermal Conductivity (W/mK) |
| Silver | 422 |
| Copper | 402 |
| Gold | 298 |
| Aluminum | 226 |
| Iron | 73.3 |
| Lead | 34.8 |

As shown in Table 1, silver has the highest thermal conductivity but it is not cost effective. Copper is more expensive than aluminum or lead, but it has relatively high thermal conductivity corresponding to aluminum or lead. Considering costs and thermal conductivity, copper may be the most suitable matter for forming the fine wires 56.

Preferably, the fine wires 56 are 0.1µm-100µm in height from the surfaces of the heat sink 50 and 1nm~100nm in width of cross-sectional area such that the volume of the heat sink 50 is not increased but instead only the surface area and surface roughness of the heat sink 50 is increased.

When the fine wires 56 with numeral size as mentioned above are not affected by air resistance because the fine wires 56 are formed to closely contact the surfaces of the heat sink 50. Therefore, the fine wires 56 can be fixedly attached on the surfaces of the heat sink 50 without using an adhesive.

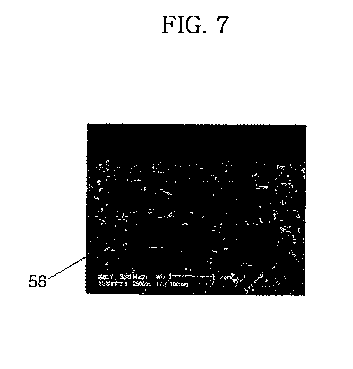

With reference to Figs. 3 to 7, a method for processing the surfaces of the heat sink according to the present invention is described in detail below.

First of all, the base 52 and heat-dissipative fins 54 are formed to form the heat sink 50. Preferably, the base 52 and heat-dissipative fins 54 of the heat sink 52 are made of aluminum having a relatively high performance of heat dissipation and requesting low manufacturing costs.

When the base 52 and heat-dissipative fins 54 of the heat sink 50 are made of aluminum, they are immersed in the copper electrolytic solution to coat their surfaces with copper by flowing electric current therein. After that, copper coating film 56' is formed on the surfaces of the base 52 and heat dissipative fins 54.

Meanwhile, even though copper has a higher efficiency of thermal conductivity corresponding to aluminum alloy, copper is difficult to be implemented with a heat sink because of its costs. If the base 52 and heat-dissipative fins 54 of the heat sink 50 made of an aluminum alloy can be implemented to coat the surfaces thereof with copper at a thickness of a few µm to tens of µm, its efficiency of thermal conductivity is as much as a heat sink made of copper while it can be manufactured at relatively costs.

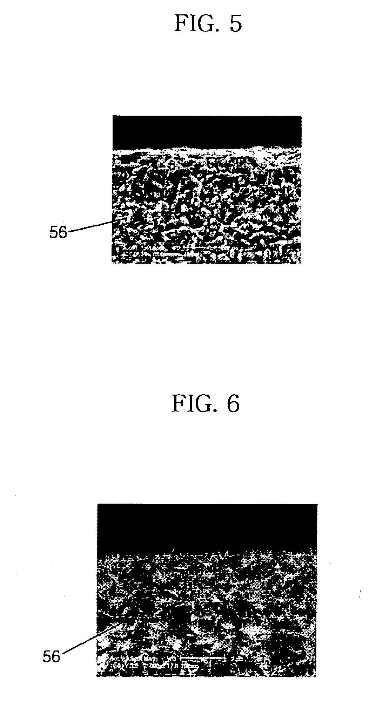

After forming copper coating film 56', the base 52 and heat-dissipated fins 54 of the heat sink 50 are immersed in an oxide solution with a predetermined temperature for a predetermined time. Then, as shown in Figs. 5 to 7, as an oxidization time lapses, copper oxides shaped as fine furs are gradually generated on the surfaces of thereof while the copper coating film 56' of the heat sink 50 is oxidized. Here, the copper oxides are formed as fine wires 56.

Additionally, the oxidization solution is implemented with NaOH or NaClO₂ such that the fine wires 56 as copper oxide can be easily grown. The fine wires 56 are easily affected by its size, density, growth rate, etc. by oxidization conditions such as the temperature of the oxidization solution and a composite, etc. For example, the fine wires are formed in a temperature of an oxidation solution of 60°C to 100°C and for an oxidation time of 1 to 10 minutes, such that they can be easily implemented in an industrial field and to comply with its productivity.

Finally, when the fine wires 56 are sufficiently grown on the surfaces of the base 52 and heat-dissipative fins 54 of the heat sink 50, they are washed by water to remove impurities thereon. Accordingly, the method for processing the surfaces of the heat sink 50 is terminated.

A method for processing the surfaces of the heat sink according to another embodiment of the present invention is described in detail below. Since the methods of another embodiment and the preferred embodiments of the present invention are similar to each other with respect to the technical idea and basic structure, a detail description of another embodiment for the same portions is omitted while citing Figs. 3 to 7.

First, the base 52 and heat-dissipative fins 54 of the heat sink 50 are made of copper having a relatively high thermal conductivity and being cost-effectively manufactured. After that, the base 52 and heat-dissipative fins 54 of the heat sink 52 are immersed in the oxidization solution with a predetermined temperature for a predetermined time.

Copper oxides shaped as fine wires 56 are gradually produced on the surfaces of the base 52 and heat-dissipative fins 54 of the heat sink 52 as the surfaces are oxidized. Here, the operation may be performed such that the surfaces of the base 52 and heat-dissipative fins 54 can be slightly oxidized.

Meanwhile, the base and heat-dissipative fins of the heat sink, materials of the fine wires, an oxidization solution for growing the fine wires, conditions for growing fine wires such as temperature of oxidization, time of oxidization etc. are just examples for implement the preferred embodiment of the present invention. Therefore, based on the factors as specifically mentioned above, those skilled in the art may modify or apply them to manufacture other heat sinks, considering heat dissipation performance and costs.

As apparent from the above description, the present invention provides a heat sink and a method for processing the surfaces of the heat sink capable of improving performance of heat dissipation of the heat sink per volume as a plurality of fine wires based on nanometer or micrometer units are grown on the surfaces of the base and heat-dissipative fins of the heat sink through an oxidation process. Here, the total volume of the heat sink is scarcely increased, but rather their surface area and surface roughness are increased.

Although the preferred embodiments of the present invention have been disclosed for illustrative purposes, those skilled in the art will appreciate that various modifications, additions and substitutions are possible, without departing from the scope and spirit of the invention as disclosed in the accompanying claims.

## Claims

1. A heat sink, comprising:
a base (52) mounted on a heat discharging element; and
at least one or more than one heat-dissipative fins (54) extending upwardly from the base (52),
wherein the base (52) or heat-dissipative fins (54) have a plurality of fine wires (56) formed on the surfaces thereof.

2. The heat sink as set forth in claim 1, wherein the plurality of fine wires (56) are copper oxide.

3. The heat sink as set forth in claim 1, wherein the plurality of fine wires (56) have 0.1µm to 100µm in height from the surfaces of the base (52) or heat dissipative fins (54) .

4. The heat sink as set forth in claim 1, wherein the plurality of fine wires (56) are 1nm to 100nm in width of cross-sectional area thereof.

5. The heat sink as set forth in claim 1, wherein the heat sink is made of copper such that the plurality of fine wires (56) are grown on the surfaces thereof while the surfaces are oxidized.

6. A method for processing surfaces of a heat sink, comprising the steps of:
immersing the heat sink in an oxide solution; and
growing fine wires (56) of oxide on the surfaces of the heat sink.

7. The method as set forth in claim 6, wherein the heat sink is coated with copper on the surfaces thereof such that the fine wires (56) can be grown thereon.

8. The method as set forth in claim 6, wherein the heat sink is made of copper such that the plurality of fine wires (56) are grown on the surfaces thereof while the surfaces are oxidized.

9. The method as set forth in claim 6, wherein the fine wires (56) have a growth temperature of 60°C to 100°C.

10. The method as set forth in claim 6, wherein the fine wires have a growth time of 1 minute to 10 minutes.

11. The method as set forth in claim 6, wherein the oxide solution includes NaOH or NaClO₂·
